# EUROPEAN PATENT APPLICATION

(11) **EP 2 692 901 A1**
(43) Date of publication of application: **05.02.2014**
(21) Application number: 12765416.8
(22) Date of filing: 15.02.2012
(51) Int. Cl.: C23C 26/00, C23C 14/08, C23C 14/34, H01L 23/14, H05K 1/09, H05K 1/16

(54) **METAL FOIL PROVIDED WITH ELECTRICALLY RESISTIVE FILM, AND METHOD FOR PRODUCING SAME**

(30) Priority: 28.03.2011 JP 2011069455
(71) Applicant: JX Nippon Mining & Metals Corporation, Tokyo 100-8164 (JP)
(72) Inventor: KUROSAWA Toshio, Hitachi-city, Ibaraki 317-0056 (JP)
(74) Representative: Hoarton, Lloyd Douglas Charles
(86) International application number: PCT/JP2012/053457
(87) International publication number: WO 2012/132592

(57) **Abstract**

Provided are: a metal foil provided with an electrically resistive film comprising nickel, chromium, silicon and oxygen; the metal foil provided with an electrically resistive film having an oxygen concentration of 20 to 60 at%; the metal foil provided with an electrically resistive film having chromium (Cr) and silicon (Si) concentrations (at%) satisfying that Cr/(Cr+Si) × 100 [%] is 73 to 79%; and the metal foil provided with an electrically resistive film having a nickel (Ni) concentration of 2 to 10 at%.

## Description

### TECHNICAL FIELD

The present invention relates to metal foil provided with an electrically resistive film layer having an appropriate resistance value, excellent flexing characteristics, and thermal stability.

### BACKGROUND ART

Copper foil is generally used as a wiring material of a printed circuit board. The copper foil is classified into electrolytic copper foil and rolled copper foil depending on the production process. The copper foil can arbitrarily control its thickness, from very thin copper foil of 5 µm to thick copper foil of about 140 µm.

The copper foil is bonded to a substrate of a resin such as an epoxy resin or a polyimide resin and is used as a board for a printed circuit. The copper foil is required to secure a sufficient strength of adhesive bonding with a resin serving as the substrate. Accordingly; in the electrolytic copper foil to be used, the rough surface called a mat surface formed during production of the foil is utilized and roughening treatment is further performed onto the rough surface in many cases. The rolled copper foil is used similarly after surface-roughening treatment in many cases.

Recently, it is proposed to further form a thin-film layer of an electrically resistive material on copper foil serving as a wiring material (see Patent Documents 1 and 2). An electronic circuit board must include an electrically resistive element, and the use of copper foil having a resistive layer allows of forming a resistive element merely by exposing the electrically resistive film layer formed on the copper foil with an etching solution such as a cupric chloride solution.

Accordingly, the limited surface area of the board can be effectively utilized by embedding the resistor in the board, compared with a conventional board necessarily having a chip resistive element mounted thereon by soldering.

In addition, restriction on design is reduced by forming the resistive element inside a multilayer board, and the circuit length can be shortened to allow improvements in electrical characteristics. Accordingly, the use of copper foil having a resistive layer makes soldering unnecessary or highly diminishes soldering, and allows a reduction in weight and an improvement in reliability. Thus, a board having an electrically resistive film embedded therein has many advantages.

The copper foil used as a base for resistive components is subjected to a surface treatment for further forming a resistive layer thereon. The copper foil differs from one for general printed board wiring, but is the same in the point of securing the strength of adhesion with a resin by roughening.

The resistive film formed on copper foil is required to have an appropriate resistance value. Since the step of forming an electronic circuit board may include thermal addition, the resistive film itself needs to have heat resistance. In addition, since the copper foil provided with a resistive film may be bent, flexing resistance such that the resistance value is not highly varied by repeated bending is necessary.

Incidentally, the present invention relates to a further improvement of the invention disclosed in Patent Document 3, which was filed by the present applicant, and it should be understood that the invention described in Patent Document 3 is all effective and can be applied to the present invention.
Patent Document 1: Japanese Patent No. 3311338
Patent Document 2: Japanese Patent No. 3452557
Patent Document 3: Japanese Patent Application No. 2007-295117

### SUMMARY OF INVENTION

### [Technical Problem]

The present invention aims at: allowing an electrically resistive material to be incorporated inside a board by forming an electrically resistive film onto a copper foil; and offering a metal foil provided with an electrically resistive film layer, in which the resistive film has an appropriate resistance value and heat resistance and the resistance value is not varied highly by repeated bending.

### [Solution to Problem]

The present inventors have diligently studied for solving the above-mentioned problems and, as a result, have found that adjustment of the composition of an electrically resistive film is effective and that, thereby, an electrically resistive film layer, of which resistance value and heat resistance are appropriate and the resistance value is not varied highly by repeated bending, can be obtained.

Based on this finding, the present invention provides the following aspects:
(1) Metal foil provided with an electrically resistive film, wherein nickel is added to an electrically resistive oxide film comprising chromium, silicon and oxygen;
(2) The metal foil provided with an electrically resistive film according to (1), wherein the electrically resistive film has an oxygen concentration of 20 to 60 at%;
(3) The metal foil provided with an electrically resistive film according to (1) or (2), wherein the chromium (Cr) and silicon (Si) components of the electrically resistive film have concentrations (at%) satisfying that Cr/(Cr+Si) x 100 [%] is 73 to 79%;
(4) The metal foil provided with an electrically resistive film according to any one of (1) to (3), wherein the nickel (Ni) component of the electrically resistive film has a concentration of 2 to 10 at%;
(5) The metal foil provided with an electrically resistive film according to any one of (1) to (4), wherein the metal foil is a copper or copper alloy foil having a foil thickness of 5 to 35 µm; and
(6) A method for producing metal foil provided with an electrically resistive film, the method including forming an electrically resistive film on metal foil using a sputtering target, in which chromium (Cr), silicon (Si), oxygen (O) and nickel (Ni) are contained, the chromium (Cr) and the silicon (Si) concentrations (at%) satisfy that Cr/(Cr+Si) × 100 [%] is 73 to 79%, the oxygen (O) concentration is 20 to 60 at%, and the Ni concentration is 2 to 10 at%.

### ADVANTAGEOUS EFFECTS OF INVENTION

The use of copper foil comprising an electrically resistive film layer does not require separately forming an electrically resistive element in designing a circuit and allows forming a resistive element merely by exposing the electrically resistive film layer formed in advance on the copper foil with an etching solution such as a cupric chloride solution. Accordingly, soldering is unnecessary or is highly diminished to give an effect of significantly simplifying mounting process.

In addition, the number of mounting components and the number of solder points on the outermost surface of a board are decreased by using the copper foil comprising an electrically resistive film layer to have a resistive element inside the board. As a result, the space on the outermost surface of the board for mounting elements other than the resistive element is increased to give an advantage of allowing a reduction in weight and size. This can expand the possibility of circuit design. In addition, embedding of the components allows shortening of the wiring length between elements and a reduction in number of junction points of different types of metals such as resistive element electrode and solder in signal wiring to give an effect of improving the signal characteristics in a high frequency region.

Furthermore, the present invention has an excellent effect of providing an electrically resistive film layer of which resistance value and heat resistance are appropriate and the resistance value is not varied highly by repeated bending.

### BRIEF DESCRIPTION OF DRAWINGS

[Fig. 1] This is a flow diagram of etching an electrically resistive film.
[Fig. 2] This is a binary-phase diagram of Cr-Si phase.

### DESCRIPTION OF EMBODIMENTS

The metal foil with an electrically resistive film according to the present invention is a metal foil provided with an electrically resistive film prepared by adding nickel to the electrically resistive oxide film comprising chromium, silicon and oxygen as the basic structural components.

Copper foil is used as a metal foil for a board in many cases, but another foil such as aluminum foil can be used. As described above, the present invention is characterized by the structure of the resistive film formed on the metal foil. In the following description, "copper foil" is exemplarily used in place of the metal foil, and "metal foil" is also used as necessary.

In addition, the usable copper foil has a foil thickness of 5 to 70 µm, in particular, 5 to 35 µm. The copper foil can have any thickness appropriately selected depending on the purpose, but it is efficient to produce copper foil having a thickness in the above-mentioned range from the restriction of production conditions.

The electrically resistive film layer can be formed by physical surface treatment such as sputtering, vacuum vapor deposition, or ion beam plating; chemical surface treatment such as a thermal decomposition method or a gas-phase reaction method; or wet surface treatment such as electroplating or electroless plating.

In general, electroplating has an advantage of producing a film at low cost. Sputtering can provide a film having a uniform thickness and isotropy, and therefore has an advantage of giving a resistive element with a high quality.

The electrically resistive film is formed according to the purpose of the film, and it is desirable to appropriately select the method of adhesion or plating of the film depending on the properties of the electrically resistive film.

In the metal foil with an electrically resistive film according to the present invention, the oxygen concentration in the electrically resistive film is preferably 20 to 60 at%. In this range, an appropriate electrical resistance value described below can be obtained.

It is possible to change the resistivity of the resulting resistive film to an intended value by controlling the oxygen concentration in the resistive film. In addition, it is possible to adjust the sheet resistance value of the resistive film to be formed by controlling the thickness of the resistive film.

However, a too small thickness of the resistive film increases the influence of surface roughness of the material to disadvantageously increase the in-plane variation of the resistance value of the resulting resistive element. In contrast, a too large thickness elongates the etching time for forming resistor by etching the resistive layer or prevents etching from being completed within a limited time and is therefore inappropriate.

From the above, usually, the thickness of the resistive film is preferably in the range of 0.01 to 0.1 µm for reducing the variation in resistance value and easily forming resistor. In order to form a resistive film having such an appropriate thickness, it is necessary to select an appropriate oxygen concentration. The above-mentioned oxygen amount is determined from this viewpoint.

The results of testing indicate that the resistance value (ohm/sq) of an electrically resistive film depends on the oxygen concentration in the film as shown in Table 1.

The results indicate that the oxygen concentration in a resistive film (target) is desirably 20 to 60 at% for forming a resistive film having an intended resistive value, from several kilo-ohms per square to one hundred and several tens kilo-ohms per square, with an appropriate thickness.

In the metal foil with an electrically resistive film according to the present invention, the chromium (Cr) and silicon (Si) components of the electrically resistive film desirably have concentrations (at%) satisfying that Cr/(Cr+Si) x 100 [%] is 73 to 79%.

The electrically resistive film of the present invention can be formed using a sputtering target containing chromium (Cr), silicon (Si), oxygen (O), and nickel (Ni), wherein the chromium (Cr) and the silicon (Si) have concentrations (at%) satisfying that Cr/(Cr+Si) x 100 [%] is 73 to 79%, the oxygen (O) has a concentration of 20 to 60 at%, the Ni has a concentration of 2 to 10 at%, and the balance is Cr and Si.

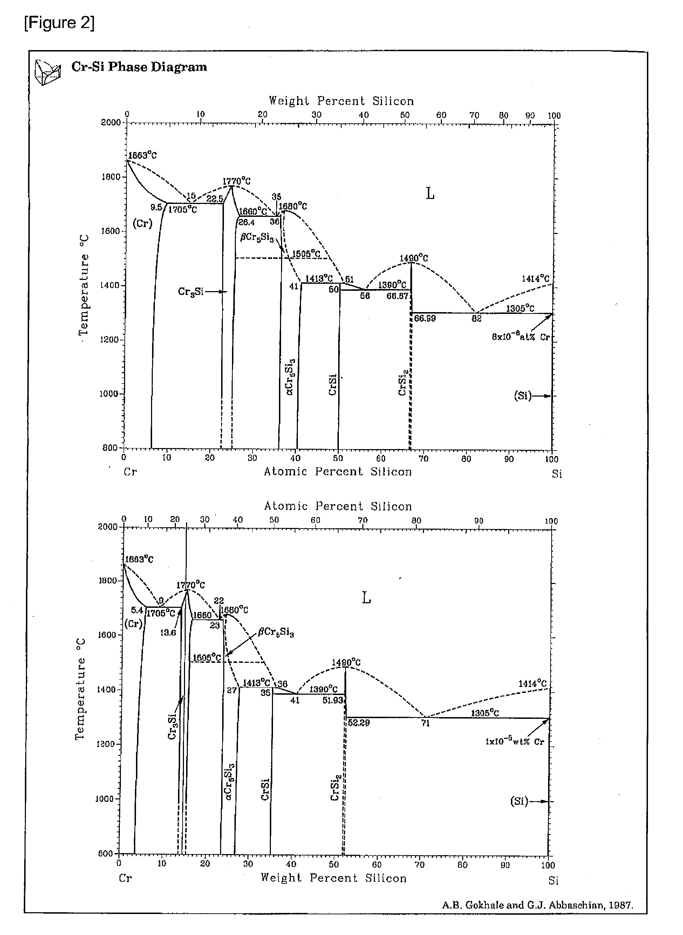

From the binary-phase diagram of Cr-Si phase shown in Fig. 2, Cr₃Si is stably present as a single phase in the region where Cr/(Cr+Si) × 100 is 73 to 79. A resistive film formed by sputtering is in an approximately amorphous state. Crystallization of a resistive film in an amorphous state progresses by receiving a thermal influence.

A resistive film in the above-mentioned composition region maintains the single phase even if the recrystallization proceeds. In contrast, for example, in a resistive film having a composition in which Cr/(Cr+Si) × 100 is 70, a state of two phases of Cr₃Si and αCr₅Si₃ is stable and forms an island or layer structure through rearrangement of the constituent atoms by receiving a thermal influence. The mechanical and electrical characteristics of the materials highly depend on the crystalline structure.

A material that does not change the crystalline structure (maintaining its single phase) by a thermal influence in the production or use of a printed board shows less characteristic change and higher stability. Accordingly, it is most preferable to select a Cr-Si ratio in the above-mentioned range from the point of characteristic change of the material. That is, a Cr-Si ratio satisfying that Cr/(Cr+Si) × 100 [%] is 73 to 79% is effective for preventing the resistive film from thermally varying.

In addition, in the metal foil with an electrically resistive film according to the present invention, the nickel (Ni) component of the electrically resistive film desirably has a concentration of 2 to 10 at%. The addition of Ni can improve the low flexing characteristics of a CrSiO resistor. Addition of Ni to CrSiO at an amount of 2% or more shows an improvement effect, but a higher improvement effect cannot be recognized in an amount of 10% or more. However, when a high resistance value is required, the concentration of the nickel (Ni) component is desirably 5 at% or less.

As a metal foil used in the metal foil provided with an electrically resistive film according to the present invention, a copper or copper alloy foil having a foil thickness of 5 to 35 µm is effective.

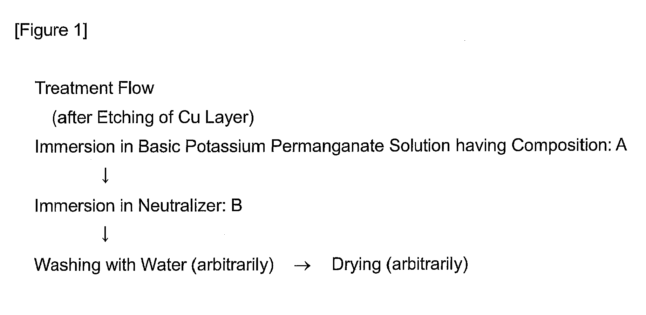

When the electrically resistive film is etched, an etching solution having the following composition A is preferably used. The neutralizer is shown below as B. The flow diagram of etching of the electrically resistive film is shown in Fig. 1.
A: Etching solution composition

| | |
|---|---|
| Potassium permanganate: | 60 g/L |
| Potassium hydroxide: | 10 g/L |
| Liquid temperature: | 49°C (120°F) |
| Treatment time: | 5 to 10 min |

B: Neutralizer

| | |
|---|---|
| Oxalic acid: | 25 g/L |
| Liquid temperature: | room temperature |
| Treatment time: | as required |

### [Examples]

Examples will now be described. These examples are intended to facilitate understanding and do not limit the present invention.

That is, modifications, embodiments, and other examples based on the technical idea of the present invention are included in the present invention.

### (Examples 1 to 6)

A NiCrSiO resistive layer was formed by sputtering on smooth foil (roughness: Rz = 0.52 µm) of electrolytic copper foil having a thickness of 18 µm. The metal composition (at%) of each target used herein was Ni/Cr/Si = 4/73/23, and the targets having oxygen concentrations shown in Table 1 were each produced by adding, during formation of the targets, an oxide of Cr or Si (such as CrO or SiO) in addition to the metal components. The composition ratio of Cr to Si was Cr/Si = 76/24 (at%) in each target.

The oxygen concentrations were, as shown in Table 1, adjusted to 20 at% in Example 1, 30 at% in Example 2, 35 at% in Example 3, 40 at% in Example 4, 50 at% in Example 5, and 70 at% in Example 6.

From the Cr-Si phase diagram, a stable intermetallic compound, Cr₃Si, is present near a ratio of Cr:Si = 75:25 (see the Cr-Si phase diagram in Fig. 2). When the ratio of Cr is 79% or more, two phases of Cr₃Si and Cr (about 6 at% of Si is solid solution) are present in a thermally stable state. When the ratio of Cr is 74% or less, two phases of Cr₃Si and Cr₅Si₃ are present in a thermally stable state.

Though a stable intermetallic compound, Cr₅Si₃, is also present near a ratio of Cr:Si = 62:38 (see the Cr-Si phase diagram in Fig. 2), Cr₅Si₃ is more fragile than Cr₃Si and is evaluated to be unsuitable as a thin-film resistive material. Accordingly, the composition ratio of Cr:Si is desirably about 75:25 (at%).

**[Table 1]**

| Oxygen concentration in target and resistance value | | |
|---|---|---|
| | Oxygen concentration at% | Resistance value Ω/sq |
| Com parative Example 1 | 10 | 501 |
| Example 1 | 20 | 1048 |
| Example 2 | 30 | 2216 |
| Example 3 | 35 | 3032 |
| Example 4 | 40 | 6008 |
| Example 5 | 50 | 9976 |
| Example 6 | 70 | 12096 |

Table 1 shows a relationship between the oxygen concentrations in targets and the resistance values. As shown in Table 1, in Example 1 where the oxygen concentration was 20 at%, the sheet resistance value was 1048 Ω/sq; in Example 2 where the oxygen concentration was 30 at%, the sheet resistance value was 2216 Ω/sq; in Example 3 where the oxygen concentration was 35 at%, the sheet resistance value was 3032 Ω/sq; in Example 4 where the oxygen concentration was 40 at%, the sheet resistance value was 6008 Ω/sq; in Example 5 where the oxygen concentration was 50 at%, the sheet resistance value was 9976 Ω/sq; and in Example 6 where the oxygen concentration was 70 at%, the sheet resistance value exceeded 12 Ω/sq. Thus, stable resistance values were obtained.

### (Comparative Example 1)

A sputtering target was produced under the same conditions as in Example 1 except that the oxygen concentration was changed, and a film was formed using this. As shown in Table 1, in Comparative Example 1 where the oxygen concentration was 10 at%, the sheet resistance value was 501 Ω/sq, which was too low and inadequate. When the oxygen concentration is higher than 70 at%, almost all of the raw materials for producing a target are oxides, and the film formed by sputtering has glassy properties to be inflexible and fragile and is therefore unsuitable for being used in an element embedding parts.

### (Examples 7 to 9)

Since CrSiO is fragile as a thin-film resistive material, Ni was added to CrSiO for improving the flexing characteristics. A reduction in oxygen concentration decreases the resistivity. Accordingly, a reduction in thickness of resistive film is necessary for giving a resistive film having a higher resistance, but the reduction increases the variation in resistance value and is therefore inappropriate. However, since Ni is expensive, a lower amount of Ni is better.

Sputtering targets in Examples 7 to 9 were produced with composition containing Ni at the amounts shown in Table 2 and having an oxygen concentration of 20 at% in the resistive film as in above-mentioned Example 1, and samples prepared by sputtering under the following conditions were investigated for flexing resistance (increase rate of resistance value after repeated bending).

The sputtering conditions were as follows:

| | |
|---|---|
| Sputtering apparatus: | 14-inch metallizer |
| Sputtering power: | 2.8 kW |
| Sputtering time: | 10 to 50 sec |
| Internal pressure of the sputtering apparatus chamber: | 3 × 10⁻³ to 6 × 10⁻³ Torr |

The flexing property was evaluated as follows:
A: Evaluation sample

| | |
|---|---|
| Base composition: | Cr:SiO = 60:40 (at%) |

B: Evaluation method
Each resistor was sputtered on a polyimide film (Upilex), and the increase of resistance value after bending of the film was measured.

| | |
|---|---|
| Apparatus (used for producing samples): | 14-inch width metallizer |
| Film thickness: | 25 µm |
| Film width (at evaluation): | 15 mm |
| Bend angle: | ±135° |
| Bend radius: | 2 mm |

The evaluation results of flexing property are shown in Table 2. The specific evaluation method shown in Table 2 is as follows. Bending was performed with an MIT bending tester.
Evaluation method: increase rate of resistance value after bending 20 times, (R/R₀) × 100
R: resistance value (ohm) after repeated bending
R₀: initial resistance value (ohm) before bending

**[Table 2]**

| Increase rate of resistance value after repeated bending | | | | |
|---|---|---|---|---|
| | Ni concentration at% | Resistance value (Ω/sq) | | Increase rate % |
| | | initial value | after bending | |
| Comparative Example 2 | 0 | 1008 | 1210 | 20.0 |
| Example 7 | 2 | 990 | 1088 | 9.9 |
| Example 8 | 5 | 1036 | 1096 | 5.8 |
| Example 9 | 10 | 997 | 1076 | 7.9 |
| Comparative Example 3 | 15 | 1039 | 1143 | 10.0 |

In the film sample in Example 7 formed using a sputtering target containing 2 at% of Ni, the initial resistance value was 990 Ω/sq, and the resistance value after bending was 1088 Ω/sq. Thus, the increase rate was 9.9% and was a satisfactory result.

In the film sample in Example 8 formed using a sputtering target containing 5 at% of Ni, the initial resistance value was 1036 Ω/sq, and the resistance value after bending was 1096 Ω/sq. Thus, the increase rate was 5.8% and was a satisfactory result.

In the film sample in Example 9 formed using a sputtering target containing 10 at% of Ni, the initial resistance value was 997 Ω/sq, and the resistance value after bending was 1076 Ω/sq. Thus, the increase rate was 7.9% and was a satisfactory result. These results are shown in Table 2.

### (Comparative Examples 2 and 3)

As shown in Table 2, sputtering targets were produced under the same conditions as those in Example 7 except that Ni was not added in Comparative Example 2 and that Ni was added at 15 at% in Comparative Example 3. Film samples were similarly formed using the sputtering targets and were investigated for flexing resistance (increase rate of resistance value after repeated bending).

The results are shown in Table 2. In the film sample in Comparative Example 2 formed using a sputtering target not containing Ni, the initial resistance value was 1008 Ω/sq, and the resistance value after bending was 1210 Ω/sq. Thus, the increase rate was 20.0%, and the resistance value highly changed, resulting in poor quality.

In the film sample in Comparative Example 3 formed using a sputtering target containing 15 at% of Ni, the initial resistance value was 1039 Ω/sq, and the resistance value after bending was 1143 Ω/sq. Thus, the increase rate was 10.0%, and the resistance value highly changed, resulting in poor quality. The results in Comparative Example 3 revealed that a too large amount of Ni leads to an increase in the variation in resistivity by bending and is therefore unfavorable.

The results of the test demonstrated that the composition ratio of each component concentration in a target is almost reproduced in the resistive film formed by magnetron sputtering. As shown in Table 2, it was revealed that the flexing characteristics were considerably improved by adding Ni in an amount of 5%, but addition of a large amount of Ni exceeding 10% makes the effect saturated and is not preferred.

### INDUSTRIAL APPLICABILITY

In the present invention, the use of copper foil with an electrically resistive film layer does not require separately forming an electrically resistive element in designing a circuit and allows forming a resistive element merely by exposing the electrically resistive film layer provided to the copper foil with an etching solution such as a cupric chloride solution. Accordingly, soldering is unnecessary or is highly diminished to give an effect of significantly simplifying mounting steps. The invention considerably diminishes the designing and producing steps of a circuit and has effect of improving the signal characteristics in a high frequency region by the resistor provided to the copper foil. Furthermore, the present invention has an excellent effect of providing an electrically resistive film layer, of which resistance value and heat resistance are appropriate and the resistance value is not varied highly by repeated bending, and therefore can be usefully applied to a printed circuit board.

## Claims

1. Metal foil provided with an electrically resistive film, wherein nickel is added to an electrically resistive oxide film comprising chromium, silicon and oxygen.

2. The metal foil provided with an electrically resistive film according to Claim 1, wherein the electrically resistive film has an oxygen concentration of 20 to 60 at%.

3. The metal foil provided with an electrically resistive film according to Claim 1 or 2, wherein the chromium (Cr) and silicon (Si) components of the electrically resistive film have concentrations (at%) satisfying that Cr/(Cr+Si) × 100 [%] is 73 to 79%.

4. The metal foil provided with an electrically resistive film according to any one of Claims 1 to 3, wherein the nickel (Ni) component of the electrically resistive film has a concentration of 2 to 10 at%.

5. The metal foil provided with an electrically resistive film according to any one of Claims 1 to 4, wherein the metal foil is a copper or copper alloy foil having a foil thickness of 5 to 35 µm.

6. A method for producing metal foil provided with an electrically resistive film, the method comprising forming an electrically resistive film on metal foil using a sputtering target, in which chromium (Cr), silicon (Si), oxygen (O) and nickel (Ni) are contained, the chromium (Cr) and the silicon (Si) concentrations (at%) satisfy that Cr/(Cr+Si) × 100 [%] is 73 to 79%, the oxygen (O) concentration is 20 to 60 at%, and the Ni concentration is 2 to 10 at%.
